# EUROPEAN PATENT SPECIFICATION

(11) **EP 4 525 265 B1**
(45) Date of publication and mention of the grant of the patent: **25.11.2026**
(21) Application number: 24221583.8
(22) Date of filing: 23.07.2020
(51) Int. Cl.: B60L 58/12, B60L 3/12, H01M 10/42, H01M 10/48, G01R 31/382, G01R 31/34, H02J 7/00, H02J 7/14, H02J 7/82, H02J 7/44, G01R 31/367, G01R 31/371

(54) **POWER-SAVING TYPE APPARATUS AND METHOD FOR MANAGING BATTERY**
ENERGIESPARENDE VORRICHTUNG UND VERFAHREN ZUR VERWALTUNG EINER BATTERIE
APPAREIL DE TYPE À ÉCONOMIE D'ÉNERGIE ET PROCÉDÉ DE GESTION DE BATTERIE

(30) Priority: 09.09.2019 KR 20190111784
(43) Date of publication of application: 19.03.2025
(62) Document number(s) of the earlier application(s) in accordance with Art. 76 EPC: 20864169.6 / 3 950 416
(73) Proprietor: LG Energy Solution, Ltd., Seoul 07335 (KR)
(72) Inventor: LEE, Ye Seul, 34122 DAEJEON (KR); YANG, Seong Yeol, 34122 DAEJEON (KR)
(74) Representative: Plasseraud IP

(56) References cited:
- JP-A- 2019 504 450
- US-A1- 2019 237 816
- US-A1- 2019 252 735

## Description

### TECHNICAL FIELD

### Cross-reference to Related Applications

This application claims the benefit of Korean Patent Application No. 10-2019-0111784, filed on September 9, 2019, in the Korean Intellectual Property Office.

### Technical Field

The present invention relates to a power-saving type apparatus and method for managing a battery, which control the sensing cycle and transmission power of a battery management system based on the state of a motor and a battery of a vehicle.

### BACKGROUND ART

In general, when a battery of an electric vehicle is low, but a driver cannot use a charging station, the battery may just be discharged. In the case of an energy storage system (ESS) used in such a vehicle, as the amount of current consumed by a battery management system (BMS) becomes less, the power consumption of a battery may be reduced, and as the replacement cycle of a module becomes long, the cost for replacing the module may be saved.

In addition, an application specific integrated circuit (ASIC) inside the battery management system reads battery cell state information according to a predetermined sensing cycle, and has a problem of consuming current to receive battery cell information switched from a sleep mode even when battery consumption is not large.

Also, in a wireless battery management system, it is common that the wireless transmission power of a master device and a slave device, which perform wireless communication, are set to a maximum value in order to minimize data loss.

Therefore, the efficient use of power in the wireless battery management system using the voltage of a battery cell as a power source is very important.

Further background art is described in JP 2019-504450 A, US 2019/176642 A1, US 2019/252735 A1 and US 2019/237876 A1.

### DISCLOSURE OF THE INVENTION

### TECHNICAL PROBLEM

An aspect of the present invention is to provide a power-saving type apparatus and method for managing a battery, which actively control the sensing cycle and transmission power of a battery management system according to the state of the use of a battery, thereby minimizing the amount of battery consumption in a wireless battery management system to use power efficiently.

### TECHNICAL SOLUTION

According to an aspect of the present invention, there is provided a battery management apparatus including a battery control unit for receiving the operation state of a motor detected and detecting the state of charge of a battery, and a condition control unit for applying a weight to at least one of the operation state of the motor and the state of charge of the battery to adjust operation conditions of the battery control unit and allowing the battery control unit to operate on the basis of the adjusted operation conditions.

The operation conditions of the battery management apparatus according to an embodiment of the present invention may include the sensing cycle of the battery, and the condition control unit may adjust a preset sensing cycle of the battery and allow the battery control unit to monitor the battery according to the adjusted sensing cycle.

The operation conditions of the battery management apparatus according to an embodiment of the present invention may include the transmission power of the battery control unit, and the condition control unit may adjust preset transmission power of the battery control unit and allow the battery control unit to transmit a signal according to the adjusted transmission power.

The condition control unit of the battery management apparatus according to an embodiment of the present invention may control the operations condition of the battery control unit using a fuzzy function.

The weight of the battery management apparatus according to an embodiment of the present invention may be determined for each preset range of the operation state of the motor and the state of charge of the battery.

The battery control unit of the battery management apparatus according to an embodiment of the present invention may receive the operation state of the motor from a motor sensing unit or a higher-level controller of a vehicle.

The battery management apparatus according to an embodiment of the present invention may further include a charge control unit for controlling the charging of the battery, wherein the state of charge of the battery may be either directly transmitted from the charge control unit to the battery control unit, or transmitted from the higher-level controller, and then transmitted from the higher-level controller to the battery control unit.

According to another aspect of the present invention, there is provided a battery management method including receiving the operation state of a motor detected, detecting the state of charge of a battery, and applying a weight to at least one of the operation state of the motor and the state of charge of the battery to adjust operation conditions of a battery control unit.

The operation conditions of the battery management method according to an embodiment of the present invention may include the sensing cycle of the battery, and the adjusting of the operation conditions of the battery control unit may adjust a preset sensing cycle of the battery and allow the battery control unit to perform monitoring the battery according to the adjusted sensing cycle.

The operation conditions of the battery management method according to an embodiment of the present invention may include the transmission power of the battery control unit, and the adjusting of the operation conditions of the battery control unit may adjust preset transmission power of the battery control unit and allow the battery control unit to transmit a signal according to the adjusted transmission power.

### EFFECTS OF THE INVENTION

According to a power-saving type apparatus and method for managing a battery of the present invention, the sensing cycle and transmission power of a battery management system is actively controlled according to the state of the use of a battery, so that the amount of battery consumption is minimized in a wireless battery management system, making it possible to use power efficiently.

### BRIEF DESCRIPTION OF THE DRAWINGS

FIG. 1 is a configuration diagram of a battery pack including a battery management system according to an embodiment of the present invention;
FIG. 2 is a block diagram showing a configuration of a battery management apparatus according to an embodiment of the present invention;
FIG. 3 is a diagram showing a method for calculating a sensing cycle in a battery management apparatus according to an embodiment of the present invention;
FIG. 4 is a flowchart showing a battery management method according to an embodiment of the present invention;
FIG. 5 is a block diagram showing a configuration of a battery management apparatus according another an embodiment of the present invention;
FIG. 6 is a diagram showing a method for calculating transmission power in a battery management apparatus according another an embodiment of the present invention;
FIG. 7 is a flowchart showing a battery management method according another an embodiment of the present invention;
FIG. 8A is a diagram showing the sensing cycle and transmission power of a battery when a vehicle is driven at a constant speed and then at a high speed;
FIG. 8B is a diagram showing the sensing cycle and transmission power of a battery when a vehicle is driven at a high speed and then at a constant speed; and
FIG. 9 is a block diagram showing a hardware configuration of a battery management apparatus according to an embodiment of the present invention.

### MODE FOR CARRYING OUT THE INVENTION

Hereinafter, various embodiments of the present invention will be described in detail with reference to the accompanying drawings. In the present document, like reference numerals are used for like elements throughout the drawings, and redundant descriptors of the like elements are omitted.

For the various embodiments of the present invention disclosed in the present document, specific structural to functional descriptions are merely illustrative of the present invention. The various embodiments of the present invention may be embodied in various forms and should not be construed as limited to the embodiments set forth herein.

Terms such as "a first," "a second," "first," and "second" used in various embodiments may modify various components regardless of the order and/or importance thereof, and do not limited the corresponding components. For example, a first component may be referred to as a second component without departing from the scope of the present invention, and similarly, a second component may also be referred to as a first component.

The terms used in this document are only used to describe specific embodiments, and may not be intended to limit the scope of other embodiments. Singular expressions may include plural expressions unless the context clearly indicates otherwise.

All the terms used herein, including technical or scientific terms, may have the same meanings as those commonly understood by those skilled in the art of the present invention. Terms that are defined in a dictionary commonly used should be interpreted as having the same or similar meaning to the meaning in the context of the related art, and should not be interpreted as having an ideal or overly formal meaning unless explicitly defined in the present document. In some cases, even the terms defined in this document should not be interpreted as excluding embodiments of the present invention.

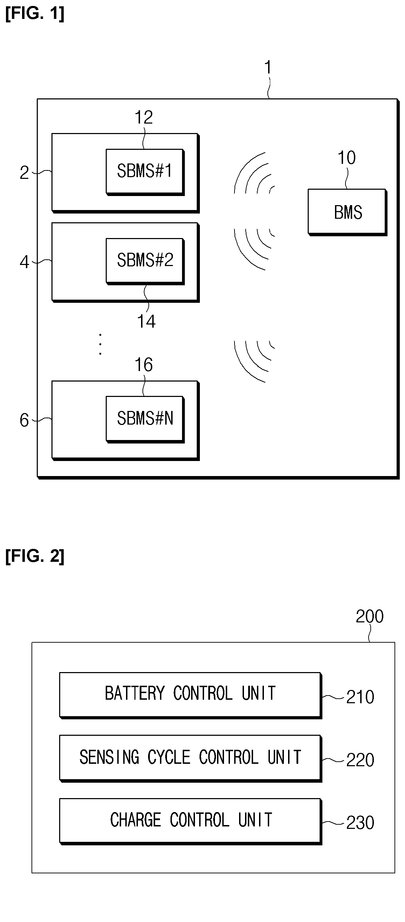

FIG. 1 is a configuration diagram of a battery pack including a battery management system according to an embodiment of the present invention.

In a battery module 1, a plurality of battery cells 2, 4, and 6 are connected either in series or in parallel. In each of the battery cells 2, 4, and 6, slave battery management systems 12, 14, and 16 are respectively disposed. Each slave battery management system 12, 14, and 16 performs monitoring by measuring the temperature, voltage, or current of the plurality of battery cells 2, 4, and 6, transmits information obtained by the monitoring to a higher-level system, and receives a battery cell control command from the higher-level to control connected battery cells.

The plurality of battery cells 2, 4, and 6 are connected either in series or in parallel to form the battery module 1. In the battery module 1, a master battery management system 10 is disposed. The master battery management system 10 performs monitoring by measuring the temperature, voltage, or current of the battery module 1. In addition, the master battery management system 10 receives monitoring information of each battery cell from the slave battery management systems 12, 14, and 16 disposed in each battery cell and transmits the same to a higher-level system, and receives a specific task performance command from the higher-level system and transmits the same to corresponding slave battery management systems 12, 14, and 16.

FIG. 2 is a block diagram showing a configuration of a battery management apparatus according to an embodiment of the present invention.

Referring to FIG. 2, a battery management apparatus 200 according to an embodiment of the present invention may include a battery control unit 210, a sensing cycle control unit 220, and a charge control unit 230. At this time, the battery management apparatus 200 may correspond to both the master battery management system and the slave battery management system of FIG. 1. In addition, according to FIG. 2, a condition control unit of the battery management apparatus 200 according to an embodiment of the present invention may be represented by the sensing cycle control unit 220.

The battery control unit 210 may receive the operation state of a motor detected, and may detect the state of charge of a battery. In this case, the battery control unit 210 may receive the operation state of the motor directly from a motor sensing unit (not shown) which detects the operation of a motor of a vehicle, or may receive the operation state of the motor from a higher-level controller.

In addition, the battery control unit 210 may perform monitoring of the battery, and may adjust the sensing cycle of the battery or the transmission power of a signal according to the state of the battery or the motor.

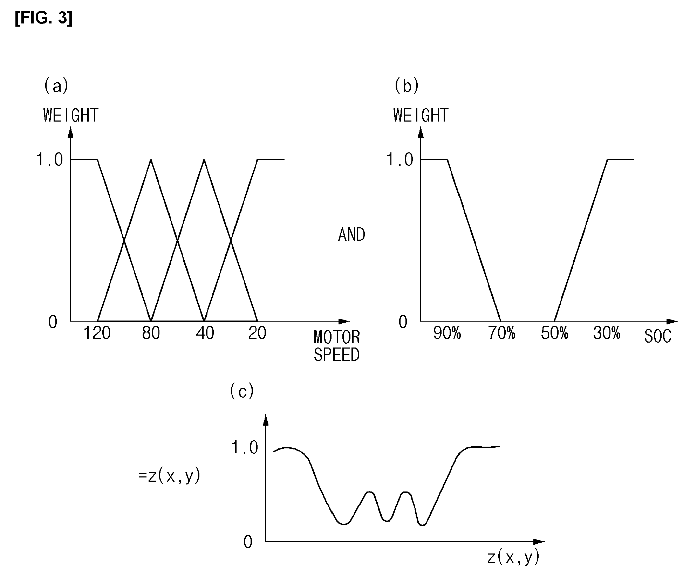

The sensing cycle control unit 220 may adjust a preset sensing cycle of a battery by applying a weight to at least one of the operation state of the motor received from the battery control unit 210 and the state of charge of the battery detected therefrom. At this time, the weight may be determined for each preset range of the operation state of the motor and the state of charge of the battery. This will be described later in detail with reference to FIG. 3.

In addition, the sensing cycle control unit 220 may allow the battery control unit 210 to perform monitoring a battery according to the adjusted sensing cycle. In this case, the sensing cycle control unit 220 may use a fuzzy function to adjust the sensing cycle of the battery as to be described later.

The charge control unit 230 may control the charging of a battery. The charge control unit 230 may transmit the state of charge of the battery directly to the battery control unit 210. In addition, the charge control unit 230 may transmit the state of charge of the battery to a higher-level controller, and then allow the same to be transmitted from the higher-level controller to the battery control unit 210.

As described above, according the battery management apparatus according to an embodiment of the present invention, the sensing cycle and transmission power of a battery management system is actively controlled according to the state of the use of a battery, so that the amount of battery consumption is minimized in a wireless battery management system, making it possible to use power efficiently.

FIG. 3 is a diagram showing a method for calculating a sensing cycle in a battery management apparatus according to an embodiment of the present invention.

Referring to FIG. 3, a weight graph (a) for the load (speed) of a motor, a weight graph (b) for the SOC of a battery, and a final sensing cycle (c) obtained by combining (1) and (b) are shown. However, the graphs of FIG. 3 are only exemplary. A weight may be calculated in various manners for each case.

For example, as shown in Graph (a) of FIG. 3, the speed of a motor may be classified according to a fuzzy rule into ranges of very high (120 km/h or greater), high (80 km/h to 120 km/h), normal (40 km/h to 80 km/h), low (20 km/h to 40 km/h), very low or stop (20km/h or less).

In addition, as shown in Graph (b) of FIG. 3, the SOC of a battery may be classified into ranges of very high (90% or greater), high (70% to 90%), normal (50% to 70%), low (30% to 50%), very low or stop (30% or less). Referring to (b) of FIG. 3, as for the SOC, if the remaining battery capacity is high, an existing sensing cycle is maintained, and if the remaining battery capacity is at an intermediate level, the weight for the sensing cycle may be reduced. If the remaining battery capacity is low, the weight for the sensing cycle may be increased to confirm the state of the battery quickly.

The AND of FIG. 3 means that the weight for the load (speed) of a motor and the weight for the SOC of a battery are summed. At this time, FIG. 3 is not limited to a logical operation AND only. A logical operation OR may also be applied according to an algorithm, and various operations such as +, x, Min, and Max may be applied.

For example, when referring to FIG. 3, when a basic sensing cycle is 100 msec, the speed of a motor is 140 km/h, and the SOC is 90%, a final sensing cycle may be calculated as follows according to the speed of the motor and the SOC of the battery.$100 msec \times z \left(140km, 90%\right) = 100 msec \times \left(1.0 AND 1.0\right) = 100 msec \times 1.0 = 100 msec$

In addition, according to the battery management apparatus according to an embodiment of the present invention, only one of the load of a motor and the SOC of a battery may be selected to adjust a sensing cycle.

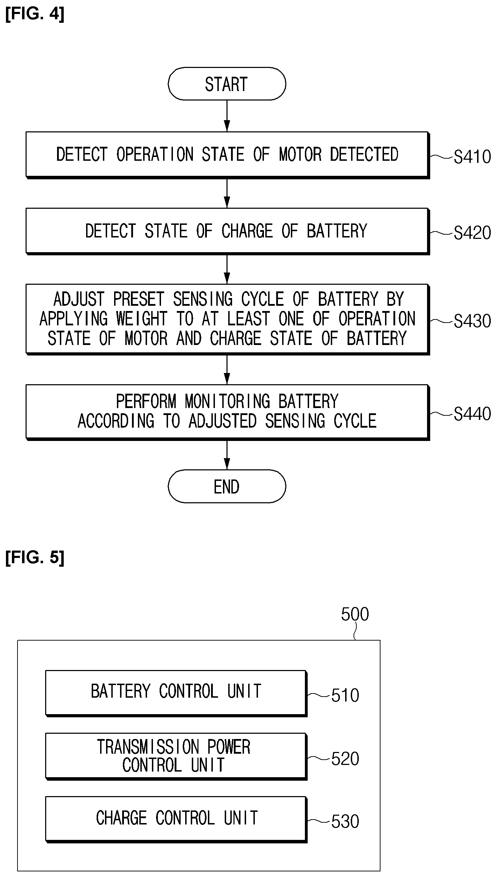

FIG. 4 is a flowchart showing a battery management method according to an embodiment of the present invention.

Referring to FIG. 4, first, the battery control unit 210 receives the operation state of a motor detected S410. At this time, the operation state of the motor may be detected by a motor sensing unit provided in a vehicle. In addition, the motor sensing unit may transmit the detected operation state of the motor directly to the battery control unit 210, or may transmit the same to the battery control unit 210 though a higher-level controller.

Then, battery control unit 210 detects the state of charge of a battery S420. In this case, the state of charge of the battery may be detected by a separate charge control unit 230. At this time, the state of charge of the battery may be transmitted directly to the battery control unit 210 from the charge control unit 230, or may be transmitted to the battery control unit 210 through a higher-level controller.

Next, a preset sensing cycle of the battery may be adjusted by applying a weight to at least one of the detected operation state of the motor and the detected state of charge of the battery S430. At this time, the sensing cycle of the battery may be adjusted using a fuzzy function. In addition, the weight for adjusting a sensing cycle may be applied to each range after dividing the operation state of the motor and the state of charge of the battery into a predetermined range.

Then, the battery control unit 210 performs monitoring of the battery according to the adjusted sensing cycle S440. As described above, according to the battery management method according to an embodiment of the present invention, the sensing cycle of a battery may be actively changed according to the state of the use of the battery, so that power may be efficiently used.

FIG. 5 is a block diagram showing a configuration of a battery management apparatus according another an embodiment of the present invention.

Referring to FIG. 5, a battery management apparatus 500 according to an embodiment of the present invention may include a battery control unit 510, a transmission power control unit 520, and a charge control unit 530. According to FIG. 5, a condition control unit of the battery management apparatus 200 according to an embodiment of the present invention may be represented by the transmission power control unit 520.

The battery control unit 510 may receive the operation state of a motor detected, and may detect the state of charge of a battery. In this case, the battery control unit 510 may receive the operation state of the motor directly from a motor sensing unit (not shown) which detects the operation of a motor of a vehicle, or may receive the operation state of the motor from a higher-level controller.

In addition, the battery control unit 510 may perform monitoring of the battery, and may adjust the sensing cycle of the battery or the transmission power of a signal according to the state of the battery or the motor.

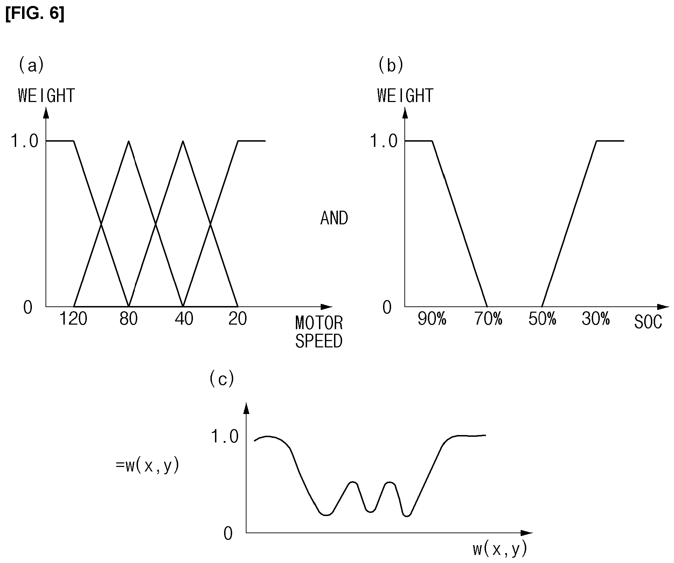

The transmission power control unit 520 may adjust a preset transmission power of the battery control unit 510 by applying a weight to at least one of the operation state of the motor received from the battery control unit 510 and the state of charge of the battery detected therefrom. At this time, the weight may be determined for each preset range of the operation state of the motor and the state of charge of the battery. This will be described later in detail with reference to FIG. 6.

In addition, the transmission power control unit 520 may allow the battery control unit 510 to transmit a signal with transmission power. In this case, the transmission power control unit 520 may use a fuzzy function to adjust the transmission power of the battery control unit 510 as to be described later.

The charge control unit 530 may control the charging of a battery. The charge control unit 530 may transmit the state of charge of the battery directly to the battery control unit 510. In addition, the charge control unit 530 may transmit the state of charge of the battery to a higher-level controller, and then allow the same to be transmitted from the higher-level controller to the battery control unit 510.

As described above, according the battery management apparatus according to an embodiment of the present invention, the sensing cycle and transmission power of a battery management system is actively controlled according to the state of the use of a battery, so that the amount of battery consumption is minimized in a wireless battery management system, making it possible to use power efficiently.

FIG. 6 is a diagram showing a method for calculating transmission power in a battery management apparatus according another an embodiment of the present invention.

Referring to FIG. 6, a weight graph (a) for the load (speed) of a motor, a weight graph (b) for the SOC of a battery, and a final transmission power (c) obtained by combining (1) and (b) are shown. However, the graphs of FIG. 6 are only exemplary. A weight may be calculated in various manners for each case.

For example, as shown in Graph (a) of FIG. 6, the speed of a motor may be classified according to a fuzzy rule into ranges of very high (120 km/h or greater), high (80 km/h to 120 km/h), normal (40 km/h to 80 km/h), low (20 km/h to 40 km/h), very low or stop (20km/h or less).

In addition, as shown in Graph (b) of FIG. 6, the SOC of a battery may be classified into ranges of very high (90% or greater), high (70% to 90%), normal (50% to 70%), low (30% to 50%), very low or stop (30% or less).

Referring to (b) of FIG. 6, as for the SOC, if the remaining battery capacity is high, existing transmission power is maintained, and if the remaining battery capacity is at an intermediate level, the weight for the transmission power may be reduced. If the remaining battery capacity is low, the weight for the transmission power may be increased to confirm the state of the battery quickly.

The AND of FIG. 6 means that the weight for the load (speed) of a motor and the weight for the SOC of a battery are summed. At this time, FIG. 6 is not limited to a logical operation AND only. A logical operation OR may also be applied according to an algorithm, and various operations such as +, x, Min, and Max may be applied.

For example, when referring to FIG. 6, when basic transmission power is 20 dBm, the speed of a motor is 140 km/h, and the SOC is 60%, final transmission power may be calculated as follows according to the speed of the motor and the SOC of the battery. In addition, in the following equation, AND was used as an average value (AAND B = (A+B)/2).$20 dBm \times z \left(140km, 60%\right) = 20 dBm \times \left(1.0 AND 0\right) = 20 dBm \times 0.5 = 10 dBm$

In addition, according to according to a battery management apparatus not covered by the present invention, only one of the load of a motor and the SOC of a battery may be selected to adjust transmission power.

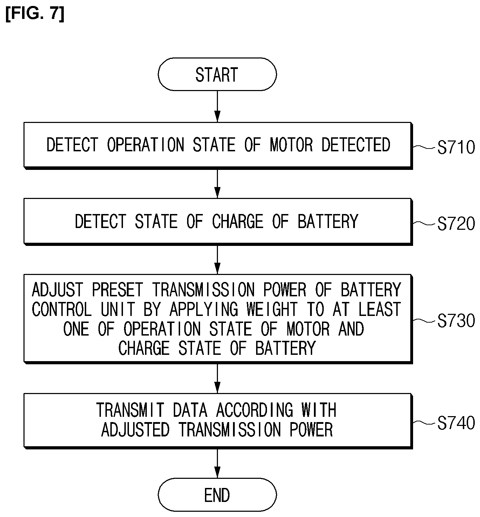

FIG. 7 is a flowchart showing a battery management method according another an embodiment of the present invention.

Referring to FIG. 7, first, the battery control unit 510 receives the operation state of a motor detected S710. At this time, the operation state of the motor may be detected by a motor sensing unit provided in a vehicle. In addition, the motor sensing unit may transmit the detected operation state of the motor directly to the battery control unit 510, or may transmit the same to the battery control unit though a higher-level controller.

Then, battery control unit 510 detects the state of charge of a battery S720. In this case, the state of charge of the battery may be detected by a separate charge control unit 530. At this time, the state of charge of the battery may be transmitted directly to the battery control unit 510 from the charge control unit 530, or may be transmitted to the battery control unit 510 through a higher-level controller.

Next, a preset transmission power of the battery may be adjusted by applying a weight to at least one of the detected operation state of the motor and the detected state of charge of the battery S730. At this time, the transmission power of the battery control unit 510 may be adjusted using a fuzzy function. In addition, the weight for adjusting transmission power may be applied to each range after dividing the operation state of the motor and the state of charge of the battery into a predetermined range.

Then, the battery control unit 510 performs monitoring of the battery according to the adjusted transmission power S740. As described above, according to the battery management method according to an embodiment of the present invention, the transmission power of the battery control unit 510 may be actively changed according to the state of the use of the battery, so that power may be efficiently used.

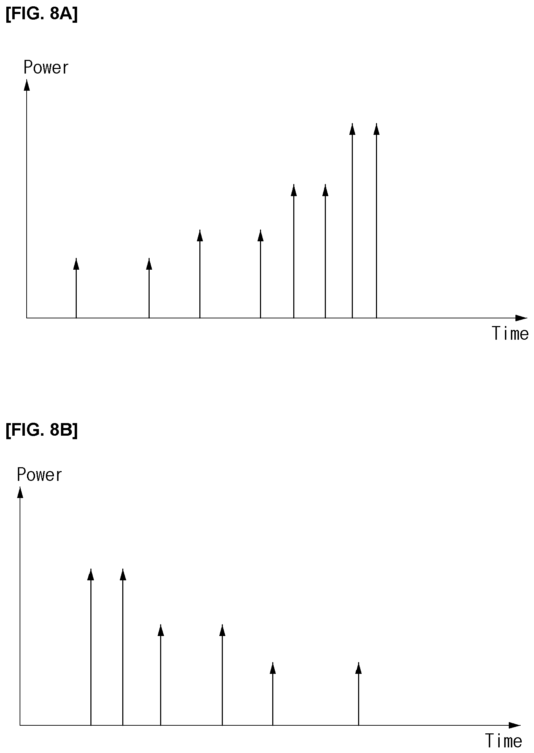

FIG. 8A is a diagram showing the sensing cycle and transmission power of a battery when a vehicle is driven at a constant speed and then at a high speed; In addition, FIG. 8B is a diagram showing the sensing cycle and transmission power of a battery when a vehicle is driven at a high speed and then at a constant speed.

Referring to 8A, when battery consumption increases rapidly, such as when a driver of a vehicle is driving at a constant speed and then gradually speeding up, enters an uphill road, or starts fast charging, the cycle of sensing the state of a battery becomes gradually shorter and communication is achieved with greater transmit power, so that the state of the battery may be monitored as accurately as possible.

Referring to FIG. 8B, when a driver of a vehicle enters a constant speed driving mode from a driving mode in which the state of a battery rapidly changes as in the above examples, the cycle of sensing the state of the battery becomes gradually longer and communication is achieved with relatively less transmission power, so that battery power may be efficiently managed without unnecessary monitoring.

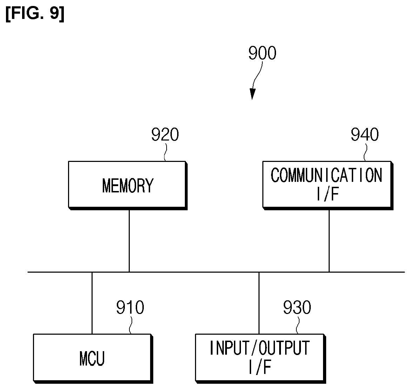

FIG. 9 is a block diagram showing a hardware configuration of a battery management apparatus according to an embodiment of the present invention.

As shown in FIG. 9, a battery management apparatus 900 may have a microcontroller (MCU) 910 for controlling various processing and each component, a memory 920 in which an operating system program, various programs (for example, a battery pack abnormality diagnosis program or a battery pack temperature estimation program), and the like are stored, an input/output interface 930 for providing an input interface and an output interface between a battery cell module and/or a switching unit (for example, a semiconductor switching element), and a communication interface 940 capable of communicating with the outside (for example, a higher-level controller) through a wired/wireless communication network. As described above, a computer program according to the present invention is stored in the memory 920 and processed by the microcontroller 910, and thus, may be implemented as, for example, a module which performs each functional block illustrated in FIG. 2.

In the above, even if all the components constituting the embodiments of the present invention have been described as being combined or combined to operate as one, the present invention is not necessarily limited to these embodiments. That is, if within the scope of the present invention, all of the components maybe selectively combined and operated as one or more.

In addition, the terms "include," "consist," or "have" as described above mean that a corresponding component may be intrinsic, unless specifically stated otherwise, and it should interpreted as including other components rather than excluding other components. All terms including technical or scientific terms have the same meanings as those commonly understood by those skilled in the art to which the present invention pertains, unless defined otherwise. Terms commonly used as those defined in a commonly used dictionary should be construed as being consistent with the context of the relevant art, and are not to be construed in an idealized or overly formal sense unless expressly defined in the present invention.

The above description is merely illustrative of the technical idea of the present invention, and those skilled in the art to which the present invention pertains may make various modifications and variations without departing from the scope of the present invention. Therefore, the embodiments disclosed in the present invention are not intended to limit the technical teaching of the present invention, but to explain, and the scope of the technical teaching of the present invention is not limited by these embodiments. The scope of protection of the present invention should be construed by the following claims, and all technical concepts within the scope of the present invention should be construed as being included within the scope of the rights of present invention.

## Claims

1. A wireless battery management apparatus (200, 500) comprising:
a battery control unit (210, 510) configured to receive the operation state of a motor of a vehicle detected by a higher-level controller of the vehicle and detect the state of charge of a battery or receive the state of charge of the battery from a charge control unit (530); and
a condition control unit (220, 520) configured to apply a weight to the operation state of the motor and the state of charge of the battery to adjust operation conditions of the battery control unit, thereby the battery control unit operates on the basis of the adjusted operation conditions,
wherein the operation state of the motor is divided into preset ranges and the state of charge of the battery is divided into preset ranges and a weight is predetermined for each preset range;
wherein:
a) the operation conditions comprise the sensing cycle of the battery, and the condition control unit (220) is configured to adjust a preset sensing cycle of the battery thereby when the battery control unit monitors the battery, it monitors the battery according to the adjusted sensing cycle; or
b) the operation conditions comprise the transmission power of the battery control unit, and the condition control unit (520) is configured to adjust preset transmission power of the battery control unit thereby when the battery control unit transmits a signal, it transmits the signal according to the adjusted transmission power.

2. The battery management apparatus of claim 1, wherein the condition control unit controls the operation conditions of the battery control unit using a fuzzy function.

3. The battery management apparatus of claim 1, further comprising the charge control unit (230, 530) configured to control the charging of the battery, wherein the state of charge of the battery is either directly transmitted from the charge control unit to the battery control unit, or transmitted to the higher-level controller, and then transmitted from the higher-level controller to the battery control unit.

4. A battery management method comprising:
receiving (S410, S710) the operation state of a motor detected through a higher-level controller of the vehicle;
detecting (S420, S720) the state of charge of a battery; and
applying (S430, S440, S730, S740) a weight to the operation state of the motor and the state of charge of the battery and adjusting operation conditions of a battery control unit based on the applied weight;
wherein:
a) the operation conditions comprise the sensing cycle of the battery, and adjusting the operation conditions comprises adjusting (S430) a preset sensing cycle of the battery, and monitoring (S440) the battery according to the adjusted sensing cycle; or
b) the operation conditions comprise the transmission power of the battery control unit, and adjusting the operation conditions comprises adjusting (S730) preset transmission power of the battery control unit, and transmitting (S740) a signal according to the adjusted transmission power.

## Patentansprüche

1. Drahtlose Batterieverwaltungsvorrichtung (200, 500), umfassend:
eine Batteriesteuereinheit (210, 510), die konfiguriert ist, um den Betriebszustand eines Motors eines Fahrzeugs zu empfangen, der durch eine übergeordnete Steuerung des Fahrzeugs erfasst wird, und den Ladezustand einer Batterie zu erfassen oder den Ladezustand der Batterie von einer Ladesteuereinheit (530) zu empfangen; und
eine Zustandssteuereinheit (220, 520), die konfiguriert ist, um eine Gewichtung auf den Betriebszustand des Motors und den Ladezustand der Batterie anzuwenden, um Betriebsbedingungen der Batteriesteuereinheit anzupassen, wodurch die Batteriesteuereinheit auf der Grundlage der angepassten Betriebsbedingungen arbeitet,
wobei der Betriebszustand des Motors in voreingestellte Bereiche unterteilt ist und der Ladezustand der Batterie in voreingestellte Bereiche unterteilt ist und eine Gewichtung für jeden voreingestellten Bereich vorbestimmt ist;
wobei:
• a) die Betriebsbedingungen den Erfassungszyklus der Batterie umfassen und die Zustandssteuereinheit (220) konfiguriert ist, um einen voreingestellten Erfassungszyklus der Batterie anzupassen, wodurch, wenn die Batteriesteuereinheit die Batterie überwacht, sie die Batterie gemäß dem angepassten Erfassungszyklus überwacht; oder
• b) die Betriebsbedingungen die Sendeleistung der Batteriesteuereinheit umfassen und die Zustandssteuereinheit (520) konfiguriert ist, um eine voreingestellte Sendeleistung der Batteriesteuereinheit anzupassen, wodurch, wenn die Batteriesteuereinheit ein Signal sendet, sie das Signal gemäß der angepassten Sendeleistung sendet.

2. Batterieverwaltungsvorrichtung nach Anspruch 1, wobei die Zustandssteuereinheit die Betriebsbedingungen der Batteriesteuereinheit unter Verwendung einer Fuzzy-Funktion steuert.

3. Batterieverwaltungsvorrichtung nach Anspruch 1, ferner umfassend die Ladesteuereinheit (230, 530), die konfiguriert ist, um das Laden der Batterie zu steuern, wobei der Ladezustand der Batterie entweder direkt von der Ladesteuereinheit an die Batteriesteuereinheit übertragen wird oder an die übergeordnete Steuerung übertragen wird und dann von der übergeordneten Steuerung an die Batteriesteuereinheit übertragen wird.

4. Batterieverwaltungsverfahren, umfassend: Empfangen (S410, S710) des Betriebszustands eines Motors, der durch eine übergeordnete Steuerung des Fahrzeugs erfasst wird; Erfassen (S420, S720) des Ladezustands einer Batterie; und Anwenden (S430, S440, S730, S740) einer Gewichtung auf den Betriebszustand des Motors und den Ladezustand der Batterie und Anpassen von Betriebsbedingungen einer Batteriesteuereinheit auf der Grundlage der angewendeten Gewichtung; wobei:
• a) die Betriebsbedingungen den Erfassungszyklus der Batterie umfassen, und das Anpassen der Betriebsbedingungen das Anpassen (S430) eines voreingestellten Erfassungszyklus der Batterie und das Überwachen (S440) der Batterie gemäß dem angepassten Erfassungszyklus umfasst; oder
• b) die Betriebsbedingungen die Sendeleistung der Batteriesteuereinheit umfassen, und das Anpassen der Betriebsbedingungen das Anpassen (S730) einer voreingestellten Sendeleistung der Batteriesteuereinheit und das Senden (S740) eines Signals gemäß der angepassten Sendeleistung umfasst.

## Revendications

1. Appareil de gestion de batterie sans fil (200, 500) comprenant :
une unité de commande de batterie (210, 510) configurée pour recevoir l'état de fonctionnement d'un moteur d'un véhicule détecté par un contrôleur de niveau supérieur du véhicule et détecter l'état de charge d'une batterie ou recevoir l'état de charge de la batterie depuis une unité de commande de charge (530) ; et
une unité de commande de condition (220, 520) configurée pour appliquer un poids à l'état de fonctionnement du moteur et à l'état de charge de la batterie afin d'ajuster des conditions de fonctionnement de l'unité de commande de batterie, de sorte que l'unité de commande de batterie fonctionne sur la base des conditions de fonctionnement ajustées,
dans lequel l'état de fonctionnement du moteur est divisé en plages prédéfinies et l'état de charge de la batterie est divisé en plages prédéfinies et un poids est prédéterminé pour chaque plage prédéfinie ; dans lequel :
• a) les conditions de fonctionnement comprennent le cycle de détection de la batterie, et l'unité de commande de condition (220) est configurée pour ajuster un cycle de détection prédéfini de la batterie de sorte que lorsque l'unité de commande de batterie surveille la batterie, elle surveille la batterie selon le cycle de détection ajusté ; ou
• b) les conditions de fonctionnement comprennent la puissance de transmission de l'unité de commande de batterie, et l'unité de commande de condition (520) est configurée pour ajuster une puissance de transmission prédéfinie de l'unité de commande de batterie de sorte que lorsque l'unité de commande de batterie transmet un signal, elle transmet le signal selon la puissance de transmission ajustée.

2. Appareil de gestion de batterie selon la revendication 1, dans lequel l'unité de commande de condition commande les conditions de fonctionnement de l'unité de commande de batterie à l'aide d'une fonction floue.

3. Appareil de gestion de batterie selon la revendication 1, comprenant en outre l'unité de commande de charge (230, 530) configurée pour commander la charge de la batterie, dans lequel l'état de charge de la batterie est soit directement transmis de l'unité de commande de charge à l'unité de commande de batterie, soit transmis au contrôleur de niveau supérieur, puis transmis du contrôleur de niveau supérieur à l'unité de commande de batterie.

4. Procédé de gestion de batterie comprenant : la réception (S410, S710) de l'état de fonctionnement d'un moteur détecté à travers un contrôleur de niveau supérieur du véhicule ; la détection (S420, S720) de l'état de charge d'une batterie ; et l'application (S430, S440, S730, S740) d'un poids à l'état de fonctionnement du moteur et à l'état de charge de la batterie et l'ajustement de conditions de fonctionnement d'une unité de commande de batterie sur la base du poids appliqué ; dans lequel :
• a) les conditions de fonctionnement comprennent le cycle de détection de la batterie, et l'ajustement des conditions de fonctionnement comprend l'ajustement (S430) d'un cycle de détection prédéfini de la batterie, et la surveillance (S440) de la batterie selon le cycle de détection ajusté ; ou
• b) les conditions de fonctionnement comprennent la puissance de transmission de l'unité de commande de batterie, et l'ajustement des conditions de fonctionnement comprend l'ajustement (S730) d'une puissance de transmission prédéfinie de l'unité de commande de batterie, et la transmission (S740) d'un signal selon la puissance de transmission ajustée.
